# EUROPEAN PATENT SPECIFICATION

(11) **EP 0 717 414 B1**
(45) Date of publication and mention of the grant of the patent: **14.03.2001**
(21) Application number: 95116185.0
(22) Date of filing: 13.10.1995
(51) Int. Cl.: G11C 11/409

(54) **Semiconductor memory**
Halbleiterspeicher
Mémoire à semi-conducteurs

(30) Priority: 16.12.1994 JP 31299094
(43) Date of publication of application: 19.06.1996
(73) Proprietor: KABUSHIKI KAISHA TOSHIBA, Kawasaki-shi, Kanagawa-ken 210-0913 (JP)
(72) Inventor: Takenaka, Hiroyuki, c/o Intell.Prop.Div., Minato-ku, Tokyo (JP)
(74) Representative: Zangs, Rainer E., Dipl.-Ing.

(56) References cited:
- EP-A- 0 031 659
- EP-A- 0 278 155
- EP-A- 0 496 406
- US-A- 5 272 665
- IEEE JOURNAL OF SOLID-STATE CIRCUITS, vol. 27, no. 11, 1 November 1992, pages 1497-1502, XP000320434 MASATO MATSUMIYA ET AL: "A 15-NS 16-MB CMOS SRAM WITH INTERDIGITATED BIT-LINE ARCHITECTURE"

## Description

### FIELD OF THE INVENTION

The present invention relates to a semiconductor memory, particularly to a dynamic-type semiconductor memory having a structure which reduces a pattern area by arranging sense amplifier arrays at both sides of a cell array in which dynamic-type memory cells are arranged in a matrix.

### BACKGROUND OF THE INVENTION

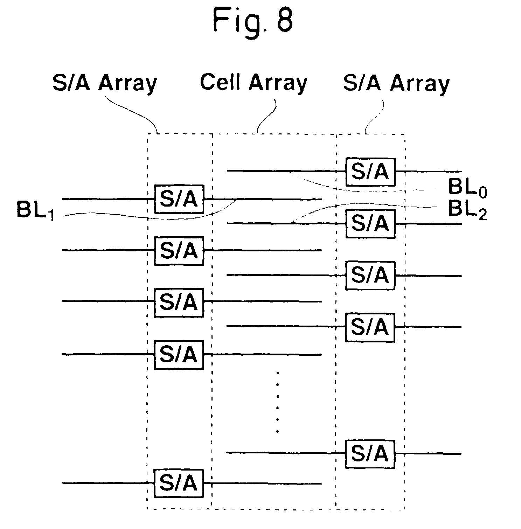

Conventionally, efforts in reducing pattern area have been successively performed in a dynamic-type semiconductor memory (hereinafter, DRAM). It is known that pattern area can considerably be reduced in a DRAM by adopting shared sense amplifier structure. Fig. 8 shows outline of a memory cell unit of a DRAM having the shared sense amplifier structure. Two sense amplifier arrays (S/A Array) are arranged at left and right ends of a memory cell array (Cell Array) having pairs of bit lines arranged in parallel with each other to interpose the memory cell array (Cell Array). Every other pair of bit lines are connected to sense amplifier circuits S/A in the left and right sense amplifier array (S/A Array). Accordingly, since amplifier circuits of a number that is half of a number of the pairs of bit lines are arranged to the right sense amplifier array and sense amplifier circuits of the same number are arranged at the left sense amplifier array, respectively. The pairs of bit lines extend on the right side and on the left side of the sense amplifier circuits, respectively and are connected to pairs of bit lines of contiguous memory cell arrays, not shown. In operation either of the right side and the left side pair of bit lines is connected to the sense amplifier circuit by a select circuit, mentioned later. For example, when a specified memory cell array (Cell Array) is activated, that is, in reading or writing or refreshing operation , the two sense amplifier arrays (S/A Array) at the left and right ends of the memory cell array are operated to amplify memory cell data.

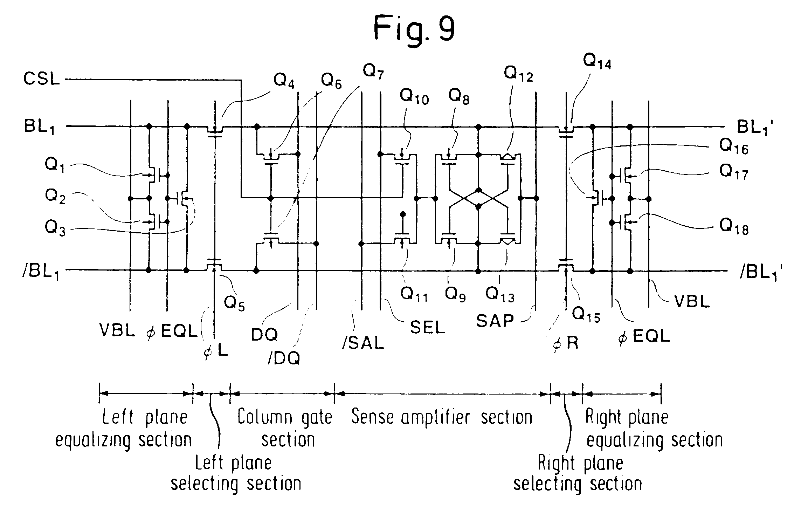

Fig. 9 shows details of the senses amplifier circuit S/A approximately illustrated in Fig. 8. This sense amplifier circuit S/A can be divided into a left plane equalizing section, a left plane selecting section, a column gate section, a sense amplifier section, a right plane selecting section and a right plane equalizing section. The left plane equalizing section is constituted by N-channel MOS transistors Q1, Q2 and Q3 and equalizes left plane pair of bit lines BL1 and /BL1 to 1/2Vcc (Vcc is internal power source potential) supplied from VBL under control of a signal φEQL. The left plane selecting section is constituted by N-channel MOS transistor 14 and 15 and connects the column gate section and the sense amplifier section to the left plane pair of bit lines BL1 and /BL1 under control of signal φL. The column gate section is constituted by N-channel MOS transistors Q6 and Q7 and selectively connects the pair of bit lines to a pair of data lines DQ and /DQ under control of a column select line CSL. The sense amplifier section is constituted by N-channel MOS transistors Q8 through Q11 and P-channel MOS transistors Q12 and Q13 in which one of the pair of bit lines having a lower potential is drawn to "L" at a timing when a N-channel sense amplifier control line /SAN falls from 1/2 Vcc to 0V. Successively, a P-channel sense amplifier control line SAP rises from 1/2 Vcc to Vcc by which a P-channel sense amplifier is operated. Here, a "H" side of the pair of bit lines is provided with a higher potential and detects a very small potential difference between the pair of bit lines. Especially with regard to a pair of bit line at a column selected by the column select line CSL amplifying operation is rapidly performed by the MOS transistor Q10. The right plane selecting section is constituted by N-channel MOS transistors Q14 and Q15 and connects the column gate section and the sense amplifier section to a right plane pair of bit lines BL1' and /BL1' under control of a signal φR. The right plane equalizing section is constituted by N-channel MOS transistors Q16, Q17 and Q18 and equalizes the right plane pair of bit lines BL1' and /BL1' to 1/2 Vcc supplied from VBL under control of a signal φR.

The explanation has been given as above with regard to a core part of a DRAM having the shared sense amplifier structure in reference to Fig. 8 and Fig. 9. It is possible by this structure to arrange the sense amplifier circuit with a pitch twice as much as a pitch (interval) of the bit lines which facilitates pattern arrangement and contributes to reduction in chip area. At the same time, the same sense amplifier array is commonly used by the contiguous memory cell arrays which makes half the sense amplifier region in comparison with a case where each sense amplifier array is exclusively provided for each memory cell array thereby contributing to reduction in chip area.

However, there are problems in the conventional DRAM having the shared sense amplifier structure as follows. That is, in case where φEQL, φEQR, VBL and the like which are used in the equalizing circuit, are formed by polysilicon wirings or wirings of impurity diffusion, the resistance is excessively large which amounts to lowering of operational margin and causing erroneous operation. However, in the mostly packed structure in which the sense amplifiers are arranged on one side at every other pair of bit lines as mentioned above, it is very difficult to arrange bypass wiring layers for φEQL, φEQR, VBL and the like which are constituted by metal wiring layers having low resistance. Because it is difficult to provide a region which brings the metal wiring layer and the high resistance wiring layer (polysilicon wiring or wiring of impurity diffusion) in contact with each other in case where the above-mentioned mostly packed structure is adopted.

As has been explained in the conventional DRAM having the shared sense amplifier structure it is difficult to bring an equalize signal line etc. in contact with a metal wiring layer at an upper layer and it is difficult to achieve low resistance since the bit line arrangement is composed of the mostly packed structure. That is, it is necessary for achieving the low resistance to sacrifice chip area by making the pitch of bit lines rather wider.

EP-A-0 031 659, to which the preamble of claim 1 refers, discloses a semiconductor memory device having a matrix area and a plurality of peripheral circuits. The memory cells are arranged at intersections of row and column wiring lines and the peripheral circuits such as sense amplifiers are connected to a predetermined number of adjacent wiring lines. Further, the peripheral circuits are arranged one after another (in ranks) when considered in a direction parallel to the lines. Especially, an arrangement of sense amplifiers at outer sides of the matrix arrangement is shown.

US-A-5,272,665 discloses a semiconductor device having a matrix of memory cells. The memory cells are crossed by word lines and bit lines. In each group of adjacent bit lines there is a special arrangement of sense amplifiers.

EP-A-0 496 406 discloses a semiconductor memory device having bit lines connected to memory cells and peripheral circuits such as sense amplifiers. The sense amplifiers are arranged at the sides of the matrix arrangement, which however consumes space between the bit lines at the respective other side of sense amplifiers.

### SUMMARY OF THE INVENTION

It is an object of the present invention to remove above-mentioned drawbacks and to provide a dynamic-type semiconductor memory achieving low resistance of equalizing signal lines and the like while maintaining a bit line arrangement of a mostly packed structure.

This object is solved by the features of the claim 1.

According to the means of the present invention it is possible to provide a constant space between the first and the second pairs of bit lines and the sense amplifier circuit opposing thereto and therefore, it is possible to provide a connection region for the signal lines. Further, it is similarly possible to provide a constant space between the third and the fourth pairs of bit lines and the sense amplifier circuit opposing thereto. Further, the mostly packed structure of the bit line arrangement is maintained as in the conventional shared sense amplifier structure. As a result, it is possible to achieve low resistance of equalize signal lines and the like without increasing chip area.

### BRIEF DESCRIPTION OF DRAWINGS

Fig. 1 is a plane view showing an embodiment of the present invention;
Fig. 2 is a plane view showing in details the embodiment of the present invention;
Fig. 3 is a plane view sowing more in details the embodiment of the present invention;
Fig. 4 is a structural diagram showing in details a sense amplifier circuit of the present invention;
Fig. 5 is a plane view showing a pattern around a clearance portion of the present invention;
Fig. 6 is a plane view showing another pattern around a clearance portion of the present invention;
Figs. 7(a) and 7(b) are plane views showing a modified example of the present invention in comparison with the embodiment;
Fig. 8 is a plane view showing a core part of a dynamic-type semiconductor memory of a conventional example; and
Fig. 9 is a structural diagram showing in detail a sense amplifier circuit of the conventional example.

### DETAILED DESCRIPTION OF PREFERRED EMBODIMENTS

An explanation will be given of embodiments of the present invention as follows in reference to the drawings.

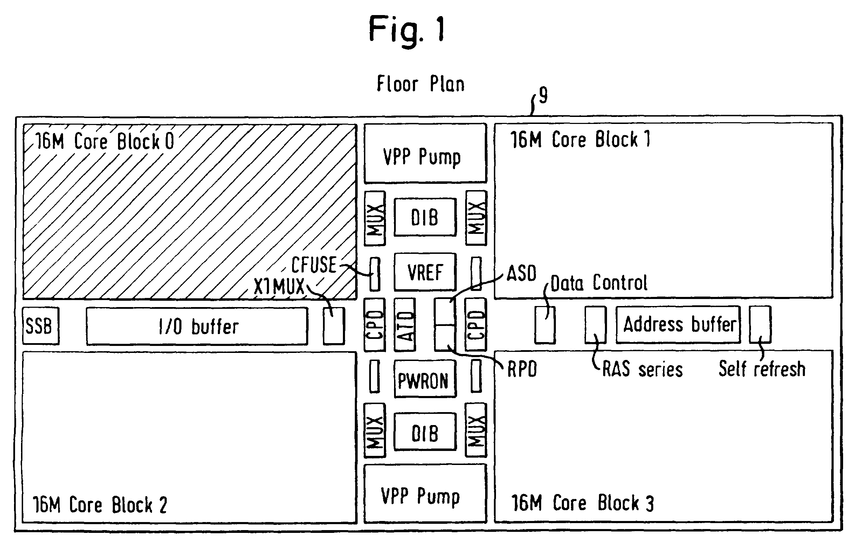

Fig. 1 shows an outline structural view of a DRAM of the present invention. The total memory capacity is assumed to be that of a 64 M bits DRAM. Core blocks CB0, CB1, CB2 and CB3 each constituted by 16 M bits memory cells and peripheral circuits within a core section such as sense amplifiers, decoders and the like accompanying the memory cells, are arranged in a semiconductor chip 9. Vpp generating circuits Vpp Pump each generating a boosted voltage Vpp of a word line, are respectively arranged between CB0 and CB1, and CB2 and CB3. Data multiplexer circuits MUX and data buffer circuits DIB are respectively arranged at data output units of the respective core blocks CB. Fuse arrays CFUSE for holding replaced data of column redundancy circuits are arranged at the vicinities of the respective core blocks. A reference potential generating circuit VREF for generating a reference potential that is an intermediate potential of 1/2 VCC etc. is arranged between CB0 and CB1. A power-on reset circuit PWRON for generating an initializing signal when the internal portion of the chip is initialized in case where power source in on, is arranged between CB2 and CB3. A substrate potential generation circuit SSB, a data input/output buffer I/O buffer and Pad, a IO data multiplexer circuit X1MUX for selecting Pad in accordance with data output width are successively arranged between CB0 and CB2. A self refresh control circuit Self refresh, an address buffer Address buffer, a row series control circuit RAS series and a data control circuit DC are successively arranged between CB1 and CB3. Further, column partial decoder circuits CPD, an address transition detection circuit ATD, a row partial decoder circuit RPD and a column address switch circuit ASD are respectively arranged at the central portion of the chip 9.

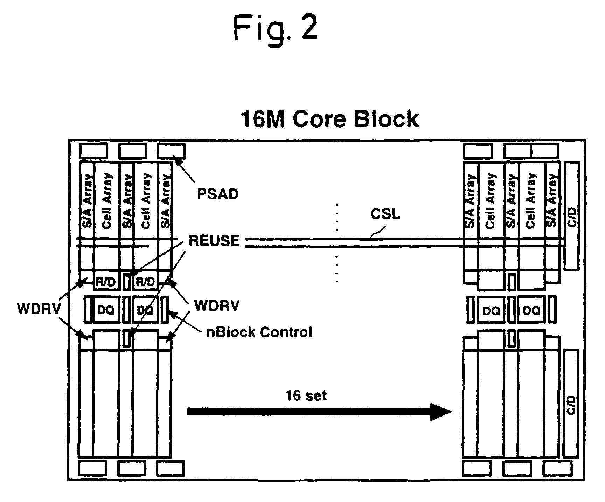

Next, Fig. 2 shows the structure of the 16 M bits core block CB. 32 sets of memory cell arrays (Cell Array) and 33 sets of sense amplifier arrays (peripheral circuits within a core section) (S/A Array) are alternately arranged constituting a memory cell block and column decoder circuits C/D are arranged at an end of the core block. A plurality of column select lines CSL are arranged in the row direction and are selectively driven by the column decoder circuits C/D. The column select lines CSL supply select signals to the sense amplifier array (S/A Array ) S/A at each row belonging to the same column. More in details the column select lines are used for partial activation of the sense amplifier circuits and for driving the column gate circuits. The memory cell block constitutes the 16 M bits core block CB by dividing it into top and bottom groups between which respectively arranged are row decoder circuits (for selectively driving word lines WL by internal row address signals) R/D each corresponding to each memory cell array, circuits WDRV for supplying drive signals to the row decoder circuits, circuits REUSE for holding replaced data of row redundancy circuits, data line amplifying circuit DQB, a block control circuit BC and the like. P-channel type sense amplifier drive circuits PSAD each corresponding to each peripheral circuit within a core section are respectively arranged at peripheral portions of the core block CB.

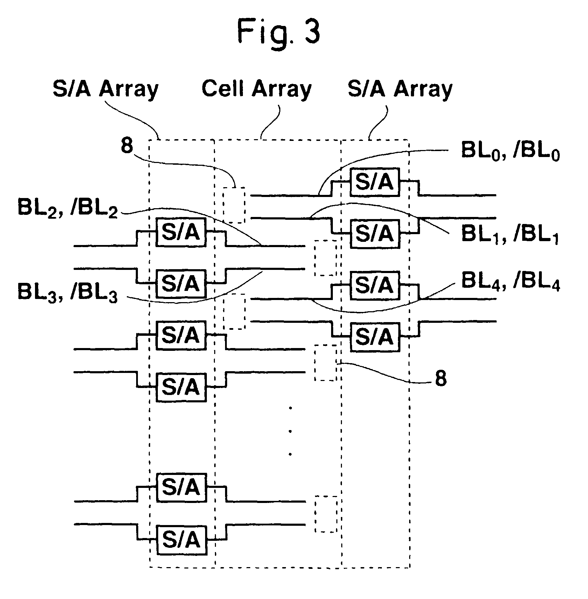

Fig. 3 shows a structure of a memory cell arrays (Cell Array) interposed by two sense amplifier arrays (S/A Array). The memory cell array is of the shared sense amplifier structure in which two pairs of bit lines BL and /BL, and BL and /BL' are respectively connected to the respective sense amplifier circuits S/A and every two sense amplifiers are grouped and the groups are arranged in a staggered arrangement as shown in Fig. 3 thereby constituting a memory cell array. Explaining in details, the locations of the sense amplifiers in view from the pairs of bit lines are on the right, right, left, left, right, right, left, left and so on, according to this embodiment although the locations are on the right, left, right, left, right, left, and so on according to the conventional example. As a result constant spaces 8 are formed respectively among the two pairs of bit lines, for example, BL0 and /BL0, and Bl1 and /BL1, and the sense amplifier arrays (S/A Array). Each bit line is connected to a dynamic-type memory cell constituted by a transistor and a capacitor, not shown. Memory cells MC belonging to the same column are connected to the same pair of bit lines and those belonging to the same row are connected to the same word line. The word lines are selectively driven by the row decode circuits R/D as mentioned above. The row decode circuit includes at least a word line driving circuit charging the word lines at "H" level by P-channel type transistors, the drive signal supply circuits WDRV are used as their drive sources and the Vpp generating circuits Vpp Pump generating a boosted potential Vpp are used as their power sources.

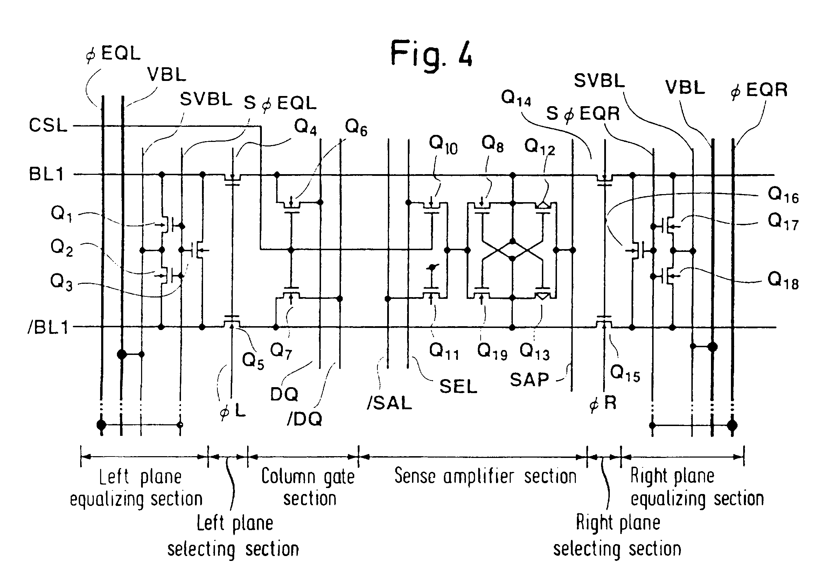

Next, Fig. 4 shows details of the sense amplifier circuit S/A in Fig. 3. Many portions in this sense amplifier circuit are the same as those in the sense amplifier circuit explained in the conventional example. The sense amplifier circuit S/A can be divided into a left plane equalizing section, a left plane selecting section, a column gate section, a sense amplifier section, a right plane selecting section and a right plane equalizing section. The left plane equalizing section is constituted by the N-channel MOS transistors Q1, Q2 and Q3 and equalizes the left plane pair of bit lines BL1 and /BL1 to 1/2 Vcc supplied by SVBL under control of a signal S φ EQL. The signal line S φ EQL is made of a polysilicon wiring, is commonly used by the gate electrodes of the MOS transistors Q1, Q2 and Q3 and is provided with comparatively high resistance although the miniaturization thereof is possible. Further, SVBL is composed of a wiring made of impurity diffusion, is commonly used for the drain electrodes of the MOS transistors Q1 and Q2 and also is provided with comparatively high resistance although the miniaturization thereof is possible. To compensate these high resistance wirings bypass lines φ EQL and VBL composed of metal wiring layers are arranged in parallel with the wirings of S φ EQL and SVBL and the both are brought into contact with each other at the regions of the spaces 8 (that is, shunted). The left plane selecting section is constituted by the N-channel MOS transistors Q4 and Q5 and connects the column gate section and the sense amplifier section to the left plane pair of bit lines BL1 and /BL1 under control of the signal φL. The column gate section is constituted by the N-channel MOS transistors Q6 and Q7 and selectively connects the pair of bit lines to the pair of data lines DQ and /DQ under control of the column select line CSL. The sense amplifier section is constituted by the N-channel MOS transistors Q8 through Q11 and the P-channel MOS transistors Q12 and Q13. The N-channel sense amplifier control line /SAN detects a "L" side line in the pair of bit lines toward the direction of 0 V at a timing when the N-channel sense amplifier control line /SAN falls from 1/2 Vcc to 0 V. Successively, the P-channel sense amplifier control line SAP detects a "H" side of the pair of bit lines toward the direction of Vcc at a timing when the P-channel sense amplifier control line SAP rises from 1/2 Vcc to Vcc. Especially with regard to the pair of bit lines of a column selected by the column select line CSL, the amplifying operation is rapidly carried out by the MOS transistor Q10. The right plane selecting section is constituted by the N-channel MOS transistors Q14 and Q15 and connects the column gate section and the sense amplifier section to the right plane pair of bit lines BL1' and /BL1' under control of φ R. The right plane equalizing section is constituted by the N-channel MOS transistors Q16, Q17 and Q18 and equalizes the right plane pair of bit lines BL1' and /BL1' to 1/2 Vcc supplied from SVBL under control of a signal S φ EQR. The signal line S φ EQR is made of a polysilicon wiring and commonly used by the gate electrodes of the MOS transistors Q16 and Q17 and Q18 as mentioned later and is provided with comparatively high resistance although the miniaturization thereof is possible. Further, SVBL is composed of a wiring made of impurity diffusion as mentioned above, is commonly used by the drain electrodes of the MOS transistors Q17 and Q18 and also is provided with a comparatively high resistance although the miniaturization thereof is possible. To compensate these high resistance wirings bypass lines φ EQR and VBL composed of metal wiring layers are arranged in parallel with the wirings of S φ EQR and SVBL and the both are brought into contact with each other in the regions of the spaces 8, (that is, shunted).

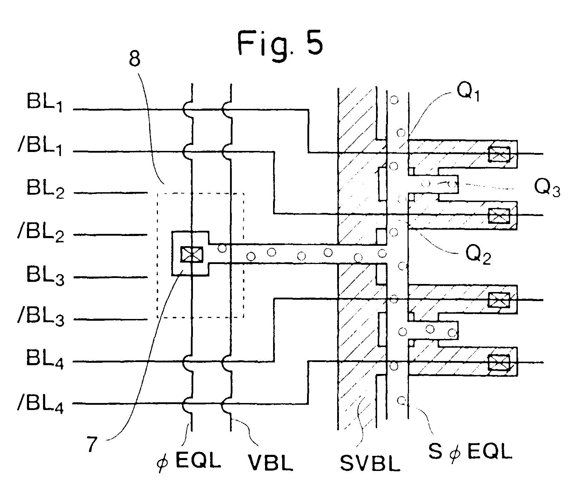

Fig. 5 shows a pattern diagram of the spaces 8 and its surrounding. A contact section 7 bringing the metal wiring and the polysilicon wiring in contact with each other and requiring a comparatively large region, is formed in the space 8 which is a region contiguous to end portions of the pair of bit lines BL2 and /BL2 and the pair of bit lines BL3 and /BL3 and which is surrounded by the two pairs of bit lines BL1 and /BL1 and BL4 and /BL4 and equalizing circuits in the sense amplifier array (MOS transistors Q1, Q2, Q3 etc.). At the contact section 7 φ EQL composed of a metal (aluminum or tungsten) wiring layer of low resistance having a width of 0.7 µm, is connected to S φ EQL composed of a polysilicon wiring layer of a comparatively high resistance having a width of 0.35 µm. S φ EQL made of the polysilicon wiring layer is commonly used by the gate electrodes of the MOS transistors Q1, Q2 and Q3 and vertically traverses the memory cell array. Further, the hatched portion designates an impurity diffusion layer. It is not necessary to provide the contact region 7 at every space 8 and the space 8 may be provided at every other group of sense amplifiers. In this case, the vacant clearance 8 is used for shunting VBL, mentioned later.

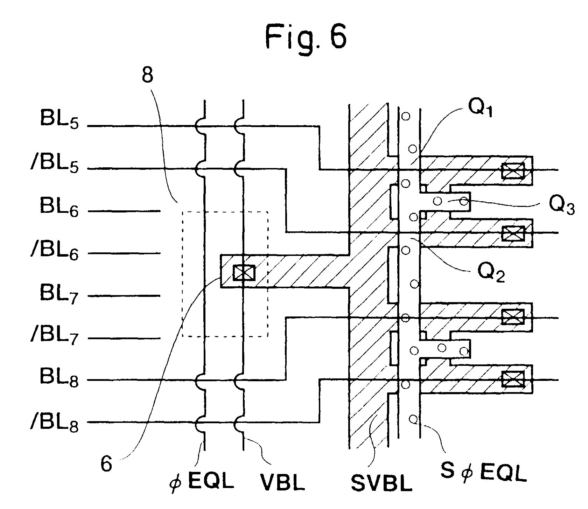

Fig. 6 shows a pattern diagram of the space 8, another member and its surrounding. A contact section 6 bringing the metal wiring and the impurity diffusion region in contact with each other and requiring also a comparatively large region, is formed in the space 8 that is a region contiguous to end portions of the pairs of bit lines BL6 and /BL6 and BL7 and /BL7 and which is surrounded by the two pairs of bit lines BL5 and /BL5 and BL8 and /BL8 and the equalizing circuits in the sense amplifier array (MOS transistors Q1, Q2 and Q3 etc.). (Naturally, it is possible to draw the electrode from the impurity diffusion region to the polysilicon layer once and connect the polysilicon layer to the metal wiring layer. This case is the same as the case explained by using Fig. 4.) In the contact section 6 VBL made of a metal wiring layer of low resistance having a width of 0.7 µm is connected to SVBL composed of a wiring made of impurity diffusion layer of comparatively high resistance having a width of 0.35 µm. SVBL composed of the impurity diffusion layer is commonly used by the drain electrodes of the MOS transistors Q1 and Q2 and vertically transverses the memory cell array. Further, the hatched portion designates the impurity diffusion layer.

The behavior of shunting at the space 8 has been shown in reference to Figs. 5 and 6 as mentioned above. Although the structure can naturally be used as shunting sections for other wirings, the above-mentioned structure is very preferable to the shared sense amplifier structure since the equalizing circuits are disposed at both ends of the sense amplifier circuits S/A.

In this way, it is possible to provide connection regions for signal lines by using the bit lines/sense amplifiers arrangement of the present invention since the constant spaces can be provided between the pairs of bit lines and the sense amplifiers. However, as in the conventional shared sense amplifier structure, the mostly packed structure is maintained in the bit line arrangement (that is, 1 sense amplifier can be arranged at every 2 pairs of bit lines). As a result low resistance formation of the equalizing signal lines etc. can be achieved without increasing chip area.

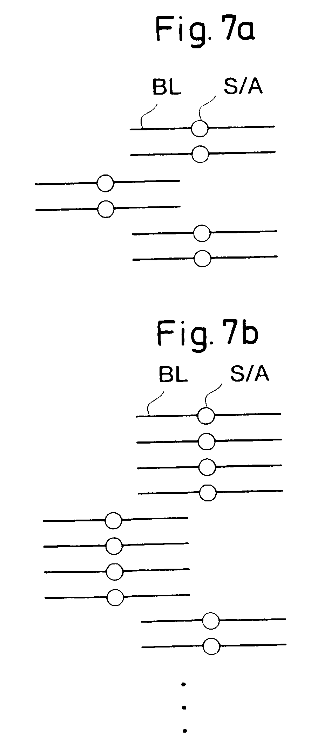

Next, an explanation will be given of a modified example of the above-mentioned embodiments in reference to Figs. 7(a) and 7 (b). Fig. 7(a) is a view approximately showing the bit lines/sense amplifiers arrangement of the above-mentioned embodiments. Fig. 7(b) shows a modified example thereof. According to the modified example, although the example is of a shared sense amplifier structure in which two pairs of bit lines are respectively connected to the left and the right of each sense amplifier circuit S/A as in the embodiments, every 4 sense amplifiers are grouped and arranged in a staggered arrangement thereby constituting a memory cell array different from the above-mentioned embodiments. Explaining in details, the locations of the sense amplifiers in view from the pairs of bit lines are on the right, right, left, left, right, right, and so on in the conventional example. By contrast, according to the modified example the locations are on the right, right, right, right, left, left, left, left, right, right, right, right, and so on. As a result, constant spaces are respectively formed between the 4 pairs of bit lines and the sense amplifier array. A large area is provided to the space in the modified example as compared with that in the above-mentioned examples. As a result this arrangement is advantageous for the generation of 256 M bits DRAM etc. wherein miniaturization of polysilicon pitch is more advanced in providing contact (shunting) among signal lines. There may be a case in which every 8 pairs of bit lines are grouped, by further advancing the embodiment in Fig. 7 (b).

Various modifications may naturally be performed within a range not deviated from the gist of the present invention.

As has been explained according to the present invention it is possible to provide a dynamic-type semiconductor memory in which low resistance of equalizing signal lines etc. is achieved while maintaining a bit line arrangement of a mostly packed structure.

## Claims

1. Semiconductor memory comprising:
a cell array including 2N, N≥2, bit line pairs arranged in columns, each of the bit line pairs being connected to a plurality of dynamic-type memories,
a first sense amplifier array having N first sense amplifier circuits arranged in a first row at one side of the cell array, each of the sense amplifier circuit being connected to N of the bit line pairs, and
a second sense amplifier array having N second sense amplifier circuits arranged in a second row at the other side of the cell array, each of the sense amplifier circuit being connected to the other N of the bit line pairs,
wherein the bit line pairs are distributed to the first and the second sense amplifier circuits by every M, M≥2, bit lines,
**characterized in that**
the bit line pairs are jogged at the end near the corresponding sense amplifier circuit to make a room for regions where a first signal line and a second signal line being shunted, and to arrange the sense amplifier circuits at regular intervals.

2. Semiconductor memory according to claim 1, further comprising regions between ends of M of the bit line pairs and the first or the second sense amplifier array, at the region a first signal line and a second signal line being shunted.

3. Semiconductor memory according to claim 2, wherein each of the sense amplifier circuits includes a equalizing circuit having first, second and third MOS transistors, the equalizing circuit equalizing the corresponding bit line pairs with an intermediate voltage, the first signal line is a wiring for controlling the first, the second, and the third MOS transistors and integral with the gates thereof, and the second signal line is a bypass wiring for supplying a control signal to the first signal line.

4. Semiconductor memory according to claim 3, wherein the first signal line is made of a polysilicon layer, and the second signal line is made of a metal wiring.

5. Semiconductor memory according to claim 2, wherein each of the sense amplifier circuits includes a equalizing circuit for equalizing the corresponding bit line pairs with an intermediate voltage, the first signal line is a wiring for providing the intermediate voltage to the equalizing circuit, and the second signal line is a bypass wiring for supplying the intermediate voltage to the first signal line.

6. Semiconductor memory according to claim 5, wherein the first signal line is made of a impurity diffusion wiring, and the second signal line is made of a metal wiring.

7. Semiconductor memory according to claim 1, wherein M is two.

8. Semiconductor memory according to claim 1, wherein M is four.

## Patentansprüche

1. Halbleiterspeicher, umfassend:
ein Zellenfeld mit 2N, N≥2, Bitleitungspaaren, die in Spalten angeordnet sind, wobei jedes der Bitleitungspaare mit einer Vielzahl von Speichern des dynamischen Typs verbunden sind;
ein erstes Leseverstärkerfeld mit N ersten Leseverstärkerschaltungen, die in einer ersten Zeile auf einer Seite des Zellenfelds angeordnet sind, wobei jede der Leseverstärkerschaltungen mit N der Bitleitungspaare verbunden ist; und
ein zweites Leseverstärkerfeld mit N zweiten Leseverstärkerschaltungen, die in einer zweiten Zeile auf der anderen Seite des Zellenfelds angeordnet sind, wobei jede der Leseverstärkerschaltungen mit den anderen N der Bitleitungspaare verbunden ist;
wobei die Bitleitungspaare an die ersten und zweiten Leseverstärkerschaltungen mit jeweils M, M≥2, Bitleitungen verteilt sind;
***dadurch gekennzeichnet, dass***
die Bitleitungspaare an dem Ende in der Nähe der entsprechenden Leseverstärkerschaltung geradegerichtet sind, um einen Raum für Bereiche zu bilden, wo eine ersten Signalleitung und eine zweite Signalleitung überbrückt sind, und um die Leseverstärkerschaltungen in regelmäßigen Intervallen anzuordnen.

2. Halbleiterspeicher nach Anspruch 1, ferner umfassend Bereiche zwischen Enden von M der Bitleitungspaare und des ersten oder des zweiten Leseverstärkerfelds, wobei an dem Bereich eine erste Signalleitung und eine zweite Signalleitung überbrückt sind.

3. Halbleiterspeicher nach Anspruch 2, wobei jede der Leseverstärkerschaltungen eine Ausgleichungsschaltung mit ersten, zweiten und dritten MOS Transistoren umfasst, wobei die Ausgleichungsschaltungen der entsprechenden Bitleitungspaare mit einer Zwischenspannung ausgleichen, die erste Signalleitung eine Verdrahtung zum Steuern der ersten, der zweiten und der dritten MOS Transistoren und integral mit den Gates davon ist, und die zweite Signalleitung eine Überbrückungsverdrahtung zum Zuführen eines Steuersignals an die erste Signalleitung ist.

4. Halbleiterspeicher nach Anspruch 3, wobei die erste Signalleitung aus einer Polysiliziumschicht gebildet ist und die zweite Signalleitung aus einer Metallverdrahtung gebildet ist.

5. Halbleiterspeicher nach Anspruch 2, wobei jede der Leseverstärkerschaltungen eine Ausgleichungsschaltung zum Ausgleichen der entsprechenden Bitleitungspaare mit einer Zwischenspannung umfasst, die erste Signalleitung eine Verdrahtung zum Bereitstellen der Zwischenspannung an der Ausgleichungsschaltung ist, und die zweite Signalleitung eine Überbrückungs-Verdrahtung zum Zuführen der Zwischenspannung an die erste Signalleitung ist.

6. Halbleiterspeicher nach Anspruch 5, wobei die erste Signalleitung aus einer Verunreinigungsdiffusionsverdrahtung gebildet ist und die zweite Signalleitung aus einer Metallverdrahtung gebildet ist.

7. Halbleiterspeicher nach Anspruch 1, wobei M zwei ist.

8. Halbleiterspeicher nach Anspruch 1, wobei M vier ist.

## Revendications

1. Mémoire semiconductrice comprenant :
un groupement de cellules comportant 2N paires de lignes de bit disposées en colonnes, où N ≥ 2, chacune des paires de lignes de bit étant connectée à une pluralité de mémoires du type dynamique,
un premier groupement d'amplificateurs de lecture possédant N premiers circuits amplificateurs de lecture disposés, suivant une première rangée, d'un côté du groupement de cellules, chacun des circuits amplificateurs de lecture étant connecté à N des paires de lignes de bit,
un deuxième groupement d'amplificateurs de lecture possédant N deuxièmes circuits amplificateurs de lecture disposés, suivant une deuxième rangée, de l'autre côté du groupement de cellules, chacun des circuits amplificateurs de lecture étant connecté aux N autres paires de lignes de bit,
où les paires de lignes de bit sont distribuées aux premiers et aux deuxièmes circuits amplificateurs de lecture par groupes de M lignes de bit, où M ≥ 2,
caractérisée en ce que :
les paires de lignes de bit sont repoussées au niveau de l'extrémité au voisinage du circuit amplificateur de lecture correspondant afin de faire de la place pour des régions où une première ligne de signal et une deuxième ligne de signal sont shuntées, et de disposer les circuits amplificateurs de lecture à intervalles réguliers.

2. Mémoire semiconductrice selon la revendication 1, comprenant en outre des régions disposées entre les extrémités de M des paires de lignes de bit et le premier ou le deuxième groupement d'amplificateurs de lecture, au niveau de la région où une première ligne de signal et une deuxième ligne de signal sont shuntées.

3. Mémoire semiconductrice selon la revendication 2, où chacun des circuits amplificateurs de lecture comporte un circuit d'égalisation possédant des premier, deuxième et troisième transistors MOS, le circuit d'égalisation égalisant les paires de bits correspondantes au moyen d'une tension intermédiaire, la première ligne de signal est un câblage servant à commander les premier, deuxième et troisième transistors MOS et solidaire de leurs grilles, et la deuxième ligne de signal est un câblage de dérivation servant à fournir un signal de commande à la première ligne de signal.

4. Mémoire semiconductrice selon la revendication 3, où la première ligne de signal est faite d'une couche de silicium polycristallin et la deuxième ligne de signal est faite d'un câblage métallique.

5. Mémoire semiconductrice selon la revendication 2, où chacun des circuits amplificateurs de lecture comporte un circuit d'égalisation servant à égaliser les paires de lignes de bit correspondantes au moyen d'une tension intermédiaire, la première ligne de signal est un câblage servant à fournir la tension intermédiaire au circuit d'égalisation, et la deuxième ligne de signal est un câblage de dérivation servant à fournir la tension intermédiaire à la première ligne de signal.

6. Mémoire semiconductrice selon la revendication 5, où la première ligne de signal est faite d'un câblage formé par diffusion d'impureté et la deuxième ligne de signal est faite d'un câblage métallique.

7. Mémoire semiconductrice selon la revendication 1, où M vaut 2.

8. Mémoire semiconductrice selon la revendication 1, où M vaut 4.
